# EUROPÄISCHE PATENTSCHRIFT

(11) **EP 1 906 126 B1**
(45) Veröffentlichungstag und Bekanntmachung des Hinweises auf die Patenterteilung: **05.06.2013**
(21) Anmeldenummer: 07017195.4
(22) Anmeldetag: 03.09.2007
(51) Int. Cl.: F28D 1/03, F28D 1/047, B60H 1/00, H01M 10/50, H05K 7/20, H01M 2/10, F28F 3/04

(54) **Vorrichtung zur Kühlung elektrischer Elemente**
Device for cooling electrical elements
Dispositif destiné au refroidissement d'éléments électriques

(30) Priorität: 25.09.2006 DE 102006045564
(43) Veröffentlichungstag der Anmeldung: 02.04.2008
(73) Patentinhaber: Behr GmbH & Co. KG, 70469 Stuttgart (DE)
(72) Erfinder: Damsohn, Herbert, Dr.-Ing., 73773 Aichwald (DE); Luz, Klaus, Dipl.-Ing., 71083 Herrenberg (DE); Pfender, Conrad, Dr.-Ing., 74354 Besigheim (DE); Gneiting, Ronald, Dipl.-Ing., 72622 Nürtingen (DE); Isermeyer, Tobias, 70736 Fellbach (DE)
(74) Vertreter: Grauel, Andreas

(56) Entgegenhaltungen:
- EP-A1- 0 512 906
- EP-A1- 1 331 665
- WO-A2-03/031884
- DE-A1- 10 223 782
- DE-C1- 19 514 548
- US-B1- 6 512 347

## Beschreibung

Die Erfindung betrifft eine Vorrichtung zur Kühlung elektrischer Elemente nach dem Oberbegriff des Anspruches 1.

EP 0 177 225 A1 beschreibt ein aktives Kühlsystem für elektrochemische Zellen, bei dem zylindrische Akkumulatoren zwischen kühlmittelführenden Kanälen im thermischen Kontakt mit den Kanälen gehalten sind, wobei die Kanäle die zylindrischen Seitenwände der elektrischen Akkumulatoren zumindest teilweise umlaufen. Die Kanäle in zu ihrem Verlauf senkrecht angeordneten Sammel- oder Verteilerräumen. Eine solche Vorrichtung ist mit erheblichem Aufwand bei der Herstellung verbunden, wobei zwischen den elektrischen Akkumulatoren große Zwischenräume verbleiben, die nicht zur Kühlung genutzt werden und somit unnötigen Bauraum beanspruchen.

Die DE 195 14 548 C1 offenbart ein Verfahren zur Herstellung einer Mikrokühleinrichtung zur wärmeleitenden außenseitigen Aufnahme von elektronischen Bauelementen.

Es ist die Aufgabe der Erfindung, eine Vorrichtung zur Kühlung elektrischer Elemente anzugeben, die bei geringem Bauraum und einfacher Herstellbarkeit eine hohe Kühlleistung bereitstellt.

Diese Aufgabe wird für eine eingangs genannte Vorrichtung efindungsgemäß mit den kennzeichnenden Merkmalen des Anspruchs 1 gelöst. Die Führung des Kanals in dem sich im Wesentlichen parallel zu der Ebene der Bodenflächen erstreckenden Kühlkörper ermöglicht eine einfache Herstellung des Kühlkörpers mit wenigen Einzelteilen. Durch die Anpassung des Kanalverlaufs an die Berandungen der elektrischen Elemente ist zudem die Verteilung der Kühlleistung und somit die benötigte Gesamtkühlleistung bei gegebener Abwärme der elektrischen Elemente optimiert.

Im Interesse einer weiteren Bauraumoptimierung ist es vorgesehen, dass die Bodenflächen der elektrischen Elemente an den Kühlkörper angrenzen. In der Regel wird der Kühlkörper dabei von den Elementen nicht berührt.

Vorteilhaft ist es vorgesehen, dass der Kühlkörper zwei gegenüberliegende Seiten aufweist, wobei auf jeder der Seiten eine Mehrzahl elektrischer Elemente aufgenommen ist. Hierdurch wird eine gegebene ebene Geometrie des Kühlkörpers zum optimierten Einsatz der Kühlleistung genutzt.

Allgemein bevorzugt sind die elektrischen Elemente gegenüber dem Kühlkörper elektrisch isoliert. Dies ermöglicht insbesondere eine serielle Verschaltung der elektrischen Elemente und somit eine hohe Betriebsspannung.

In einer bevorzugten Weiterbildung sind den elektrischen Elementen benachbarte thermische Leitkörper an dem Kühlkörper angeordnet, wobei die Leitkörper sich im Wesentlichen senkrecht zu dem Kühlkörper erstrecken und in thermischem Kontakt mit den elektrischen Elementen stehen. Hierdurch werden Zwischenräume, die zwischen den Elementen verbleiben, zur Reduktion des thermischen Widerstandes genutzt. Im Interesse einer einfachen Herstellung und guten thermischen Verbindung von Leitkörpern und Kühlkörper sind die Leitkörper dabei stoffschlüssig, insbesondere durch Verlötung, mit dem Kühlkörper verbunden. In weiterer bevorzugter Ausbildung sind zumindest einige der Leitkörper als Becher mit einer zumindest teilweise umlaufenden Wand ausgebildet, wobei jeweils ein elektrisches Element in einem der becherförmigen Leitkörper aufgenommen ist. Dies ermöglicht eine zweckmäßige Kombination einer thermischen Wärmeableitung mit einer Halterung der Elemente. Alternativ oder ergänzend sind zumindest einige der Leitkörper jeweils als ein zwischen benachbarten elektrischen Elementen angeordneter Stab ausgebildet, wodurch insbesondere bei zylindrisch geformten Elementen eine optimierte Raumnutzung bei zugleich guter Wärmeableitung von den Seitenwänden der Elemente ermöglicht ist. Unabhängig von der Formgebung der Leitkörper ist es im Interesse einer einfachen Herstellung und guten und homogenen Wärmeableitung sowie einer guten elektrischen Isolierung vorteilhaft vorgesehen, dass die Elemente stoffschlüssig, insbesondere mittels einer die Elemente einhüllenden Vergussmasse mit den Leitkörpern verbunden sind. Eine solche Vergussmasse ist zum Beispiel ein Kunststoff wie etwa Epoxydharz, der vorteilhaft mit thermisch leitfähigen Zuschlagstoffen, im Interesse einer elektrischen Isolation z. B. Keramikpulver, versehen ist.

Allgemein bevorzugt haben die elektrischen Elemente im wesentlichen die Form eines Zylinders, wobei eine Stirnfläche des Zylinders der Bodenfläche des elektrischen Elements entspricht. Solche zylindrischen Elemente sind die am weitesten verbreitete Bauform von z. B. Akkumulatoren, wobei die thermische Abwärme aufgrund der runden Seitenwand des Zylinders besonders gleichmäßig nach Außen gegeben wird.

Zur Bauraumoptimierung und Optimierung der Kühlleistung entsprechen die Berandungen der elektrischen Elemente Rändern der Bodenfläche der Elemente, wobei der Kanal zumindest abschnittsweise benachbart der Ränder mehrerer Elemente verläuft. Vorteilhaft folgt der Kanal dabei nacheinander Abschnitten der Ränder mehrerer Elemente, wobei eine Richtung des Kanals sich alternierend mit den nacheinander folgenden Elementen ändert.

Hierdurch wird die Kanallänge pro Element vergrößert und somit die Kühlleistung verbessert. In einer bevorzugten Ausführungsform kann dabei der Verlauf des Kanals entlang der Ränder im wesentlichen teilkreisförmig sein. Alternativ oder ergänzend kann der Kanal auch einen zickzackförmigen Verlauf aufweisen.

In einer alternativen oder ergänzenden Ausführung verzweigt sich der Kanal in seinem Verlauf in zumindest zwei Teilkanäle. Insbesondere in Randbereichen des Kühlkörpers, in denen der Kanal nur auf einer Seite an Elementen entlang läuft, ist eine solche Verzweigung zur gleichmäßigen Verteilung der Kühlleistung sinnvoll. Bevorzugt haben die zumindest zwei Teilkanäle dabei in der Summe etwa den gleichen Strömungsquerschnitt wie der unverzweigte Kanal.

In einer bevorzugten Ausführungsform der Erfindung ist der Kanal als Einfräsung in einem plattenartigen Metallteil, insbesondere aus Aluminium, ausgebildet. Hierdurch ist ein besonders komplexer Kanalverlauf ermöglicht.

Alternativ oder ergänzend kann der Kanal auch als gebogenes Rohr, insbesondere als Strangpressprofil mit bevorzugt mehreren Kammern, ausgebildet sein, was eine kostengünstige und einfache Herstellung sowie eine große Wandfläche pro Längeneinheit des Kanals ermöglicht.

Weiterhin vorteilhaft umfasst der Kühlkörper zumindest zwei insbesondere parallel verschaltete Kanäle. Je nach Größe des Kühlkörpers und Anzahl der elektrischen Elemente ist eine solche Parallelschaltung von Kanälen gewünscht, um möglichst sämtlichen Elementen eine annähernd gleiche Kühlleistung zukommen zu lassen. In diesem Sinne besonders vorteilhaft ist es, dass die zumindest zwei Kanäle im wesentlichen die gleiche Länge aufweisen. Besonders bevorzugt weicht die Länge des zweiten Kanals dabei von der Länge des ersten Kanals um nicht mehr als etwa 40 %, insbesondere vorteilhaft um nicht mehr als etwa 20 % ab, um eine gleichmäßige Verteilung der Kühlleistung über sämtliche Elemente zu gewährleisten. Alternativ oder ergänzend haben zudem die zumindest zwei Kanäle jeweils einen im wesentlichen konstanten Strömungsquerschnitt von im wesentlichen gleicher Größe. Bevorzugt unterscheidet sich dabei der Strömungsquerschnitt des zweiten Kanals von dem Strömungsquerschnitt des ersten Kanals um nicht mehr als etwa 30 %, insbesondere um nicht mehr als etwa 15 %. Auch diese Maßnahmen tragen dazu bei, dass sämtlichen der elektrischen Elemente die im wesentlichen gleiche Kühlleistung zukommt.

In vorteilhafter Ausführung sind die elektrischen Elemente Akkumulatoren, insbesondere Lithium-lonen-Batterien. Bei derartigen Bauteilen besteht nicht nur hinsichtlich der Leistungsfähigkeit sondern auch hinsichtlich der Lebensdauer eine unter Umständen deutliche Abhängigkeit von der Betriebstemperatur. Daher sind diese Elemente in besonderem Maße für die Kombination mit einer erfindungsgemäßen Vorrichtung geeignet, da die Homogenisierung der Kühlleistung über die elektrischen Elemente erhebliche Einflüsse auf Wartungsinterwalle hat, die letztlich durch das elektrische Element mit der geringsten Lebenserwartung bestimmt sind.

Besonders bevorzugt ist der Kühlkörper an einen Kältekreis einer Klimaanlage eines Kraftfahrzeugs angeschlossen, wobei das Kühlmittel ein Kältemittel der Klimaanlage ist. Hierdurch können besonders niedrige Betriebstemperaturen der elektrischen Elemente erreicht werden, was ihrer Lebensdauer zuträglich ist. Besonders gilt dies für Lithium-lonen-Batterien, bei denen sogar eine Kühlung auf Betriebstemperaturen unterhalb von typischen Umgebungstemperaturen die Lebensdauer noch deutlich verbessern kann. Bei Anschluss des Kühlkörpers an eine Klimaanlage kann das Kältemittel in dem Kanal sowohl weitgehend in flüssiger Phase als auch je nach angeforderter Kühlleistung unter teilweisem oder vollständigem Phasenwechsel in die Gas-Gasphase den Kühlkörper durchströmen. Hierdurch ist eine besonders schnelle Reaktion auf einen ansteigenden Kühlleistungsbedarf ermöglicht.

In einer bevorzugten Ausführungsform ist das Kältemittel dabei R134a. Es kann sich aber auch um ein anderes Kältemittel wie etwa Kohlendioxid handeln.

Bei einer bevorzugten Detaillösung ist der Kühlkörper in Parallelschaltung in dem Kältekreis angeordnet. Insbesondere bei einer solchen Anordnung kann der Kühlkörper auf einfache Weise in bestehende Kältekreise von Kraftfahrzeugen integriert werden, ohne dass deren Auslegung in größerem Umfang geändert werden muss. Zudem kann auf besonders einfache Weise der Kühlkörper aus dem Kältekreis ausgenommen werden, wenn z. B. wenig Kühlleistungsbedarf für die elektrischen Elemente besteht. In bevorzugter Verschaltung zweigt dabei eine Zuführung des Kältemittels nach einem Sammler des Kältekreises ab und insbesondere bevorzugt vor einem Expansionsorgan des Kältekreises. Ebenso bevorzugt mündet eine Abführung des Kältemittels von dem Kühlkörper vor einem Verdampfer des Kältekreises und insbesondere nach einem Expansionsorgan des Kältekreises ein, um eine Nachverdampfung von noch flüssigem Kältemittel zu ermöglichen. Im Interesse einer optimalen Kühlfunktion ist vor dem Kühlkörper ein Expansionsorgan seriell zu dem Kühlkörper angeordnet, wobei in kostengünstiger Bauweise das Expansionsorgan insbesondere als Festdrossel ausgebildet ist. Alternativ kann es sich aber auch um ein thermostatisches Expansionsventil handeln.

Im Interesse einer modularen und kostengünstigen Bauweise sind eine Abzweigung des Kältekreises zu dem Kühlkörper und eine Einmündung von dem Kühlkörper jeweils in einem Expansionsorgan des Kältekreises baulich integriert. Hierdurch ist vor allem ein optionaler modularer Anbau einer erfindungsgemäßen Vorrichtung an den Kältekreis einer Klimaanlage eines Kraftfahrzeugs kostengünstig ermöglicht. Dabei kann ein herkömmliches Expansionsorgan durch die baulich integrierte Einheit ersetzt werden. Alternativ kann die baulich integrierte Einheit vorgesehen werden, wobei die Anschlüsse für den Kühlkörper bei Nichtvorsehen des Kühlkörpers versiegelt sind.

In weiterhin vorteilhafter Detailausführung ist der Kältemittelstrom durch den Kühlkörper über ein ansteuerbares Ventil veränderbar. Dies kann zum Beispiel ein getaktetes Magnetventil sein, wobei aufgrund der thermischen Trägheit der Systeme und aus Gründen der Standzeit des Magnetventils die Taktzeiten regelmäßig relativ lang sind. Hierdurch kann die Verteilung der Kühlleistung bzw. des Kältemittelmassenstroms auf den Kühlkörper und den herkömmlichen Verdampfer der Klimaanlage einstellbar veränderbar sein.

Bei einer optimierten Ausführungsform insbesondere für eine Klimaanlage für ein Kraftfahrzeug hat der Kanal eine Länge von weniger als etwa 1000 mm, insbesondere von etwa 650 mm. Ein Strömungsquerschnitt des Kanals liegt in optimierter Ausführung zwischen etwa 5 mm² und etwa 170 mm², insbesondere bevorzugt zwischen etwa 30 mm² und etwa 50 mm². Ein totaler Kältemittelstrom durch den Kühlkörper beträgt in optimierter Ausführung zwischen etwa 4 g/sek. und etwa 5 g/sek. Bei diesen Größenordnungen hat sich eine erreichbare Kühlleistung von etwa 0,5 kW bei weitgehend homogenisierter Verteilung der Kühlleistung über die Elemente herausgestellt. Dies erfüllt Anforderungen an die Kühlung elektrischer Elemente insbesondere in Personenkraftwagen. Zum Beispiel handelt es sich dabei um Hybridfahrzeuge, die einen elektrischen Zusatzantrieb zu einem Verbrennungsmotor haben, wobei die elektrischen Elemente eine Energiequelle für den Elektromotor darstellen.

Bei dem erfindungsgemäßen Ausführungsbeispiel nach Anspruch 1 ist der Kühlkörper als Stapel aus einer Mehrzahl von plattenförmigen Elementen ausgebildet. Hierdurch wird die Herstellung des Kühlkörpers besonders kostengünstig Bevorzugt umfasst der Stapel dabei im Interesse einer einfachen Herstellung ein mittleres Plattenteil, wobei das mittlere Plattenteil eine Durchbrechung zur Ausbildung des Kanals aufweist. Besonders bei aufwendig geformten Kanälen kann das mittlere Plattenteil dabei zumindest zwei separate, nicht einstückig ausgebildete Segmente umfassen. Zweckmäßig sind diese Segmente zur Verringerung des Materialverschnitts dabei aus einer einzigen Platte ausgeschnitten.

In einer vorteilhaften Weiterbildung weist das mittlere Plattenteil eine Mehrzahl von insbesondere kreisförmigen Durchbrechungen auf, wobei die Durchbrechungen in Überdeckung mit den Bodenflächen der elektrischen Elementen angeordnet sind. Hierdurch werden Ausweichöffnungen bereitgestellt, die ein kontrolliertes Bersten der elektrischen Elemente im Fall einer Überhitzung oder anderen Betriebsstörung ermöglichen. Zugleich verringern solche zusätzlich zu dem Kanal vorgesehene Durchbrechungen das Gewicht des Kühlkörpers.

Allgemein vorteilhaft ist auf dem mittleren Plattenteil zumindest eine Deckplatte dichtend festgelegt. Hierdurch können die den Kanal formenden Durchbrechungen des mittleren Plattenteils auf einfache Weise zum Kanal geschlossen beziehungsweise vervollständigt werden. Besonders bevorzugt sind mittleres Plattenteil und Deckplatte dabei flächig miteinander verlötet, wodurch bei einfacher Herstellung, zum Beispiel in einem Lötofen, eine besonders druckfeste Verbindung gegeben ist. Grundsätzlich kann aber auch eine andere stoffschlüssige Festlegung zum Beispiel mittels eines Klebstoffs oder auch eine mechanische Festlegung, insbesondere unter Verwendung von Dichtmitteln, vorgesehen sein.

In der erfindungsgemäßen Ausführung ist auf der dem mittleren Plattenteil gegenüberliegenden Seite der Deckplatte ein weiteres Plattenteil festgelegt. Ein solches weiteres Plattenteil kann insbesondere zur Halterung und thermischen leitenden Anbindung von Leitkörpern ausgebildet sein oder auch zur mechanischen Positionierung der elektrischen Elemente.

Im Interesse einer einfachen Herstellung weisen zumindest einige der plattenförmigen Elemente eine flächige Lotplattierung auf. Hierdurch können die mechnisch vormontierten Teile des Kühlkörpers zum Beispiel in einem Lötofen stoffschlüssig aneinander festgelegt werden. Bevorzugt bestehen dabei die plattenförmigen Elemente aus einer Leichtmetalllegierung, insbesondere auf Basis von Aluminium, Solche Bauteile sind einfach flächig verlötbar, kostengünstig formbar und weisen ein geringes Gewicht bei hoher Druckfestigkeit und guter Wärmeleitung auf.

Die Aufgabe der Erfindung wird für zudem durch ein Herstellungsverfahren mit den Schritten nach Anspruch 41 gelöst. Ein solches Herstellungsverfahren ist besonders kostengünstig und zur automatisierten Produktion großer Stückzahlen der erfindungsgemäßen Vorrichtung geeignet.

In bevorzugter Ausführung eines Herstellungsverfahrens umfasst Schritt c. ein flächiges Verlöten der Deckelteile an dem mittleren Plattenteil, insbesondere durch Einbringen der aufeinander angeordneten plattenförmigen Teile in einen Lötofen.

Weiterhin vorteilhaft kann die Durchbrechung des mittleren Plattenteils mittels Laserschneiden eingebracht werden, wodurch eine aufwendige Kanalführung bei geringen Herstellungskosten ermöglicht ist. Alternativ hierzu kann die Durchbrechung des mittleren Plattenteils aber auch mittels Stanzen eingebracht werden, wodurch eine weitere Kostenreduzierung insbesondere bei Fertigung großer Stückzahlen ermöglicht ist.

In bevorzugter Weiterbildung des Herstellungsverfahrens werden in einem Verfahrensschritt eine Mehrzahl von sich im Wesentlichen senkrecht zu dem mittleren Plattenteil erstreckenden Leitkörpern angebracht, insbesondere mittels Verlöten. Das Anbringen der Leitkörper zur Verbesserung der Wärmeableitung von den elektrischen Elementen kann dabei ebenfalls mittels Lotplattierungen erfolgen, wobei nach einer mechanischen Vormontage die Verlötung der Komponenten des Kühlkörpers in einem Lötofen erfolgt.

Eine weitere Verringerung der Herstellungskosten umfasst einen Verfahrensschritt des Positionierens der elektrischen Elemente relativ zu dem Kühlkörper und Aufbringen einer Vergussmasse zwischen den Elementen und dem Kühlkörper. Hierdurch kann auf mechanische Ausformungen und insbesondere zusätzliche, elektrisch isolierende Adapter zur Positionierung der Elemente gegenüber dem Kühlkörper verzichtet werden.

Die Erfindung betrifft zudem ein Kraftfahrzeug, insbesondere einen Personenkraftwagen, mit den Merkmalen des Anspruchs 47. Die erfindungsgemäße Vorrichtung zur Kühlung der elektrischen Elemente ist besonders gut als Energiequelle für einen Antriebs-Elektromotor eines Personenkraftwagens geeignet. In besonders bevorzugter Ausführung hat das Kraftfahrzeug einen Hybrid-Antrieb aus dem Elektromotor und einem Verbrennungsmotor.

Weitere Vorteile und Merkmale der Erfindung ergeben sich aus den nachfolgend beschriebenen Ausführungsbeispielen sowie aus den abhängigen Ansprüchen.

Nachfolgend werden mehrere bevorzugte Ausführungsbeispiele einer erfindungsgemäßen Vorrichtung beschrieben und anhand der anliegenden Zeichnungen näher erläutert.
- Fig. 1: zeigt eine Draufsicht auf einen teilweise montierten Kühlkörper eines ersten Ausführungsbeispiels der Erfindung.
- Fig. 2: zeigt eine schematische Draufsicht auf den Kühlkörper einer erfindungsgemäßen Vorrichtung gemäß einem zweiten Ausführungsbeispiel.
- Fig. 3: zeigt eine Draufsicht auf ein drittes Ausführungsbeispiel einer erfindungsgemäßen Vorrichtung.
- Fig. 4: zeigt eine Schnittansicht der Ausführung aus Fig. 3 entlang der Linie A-A.
- Fig. 5: zeigt eine Draufsicht auf die Vorrichtung aus Fig. 3 in einem teilweise montierten Zustand.
- Fig. 6: zeigt eine Detailvergrößerung des Bereichs B aus Fig. 4.
- Fig. 7: zeigt eine Darstellung eines zweiflutigen Kanals der Vorrichtung aus Fig. 5.
- Fig. 8: zeigt eine schematische Darstellung eines Kältekreises mit integrierter erfindungsgemäßer Vorrichtung.
- Fig. 9: zeigt eine räumliche Explosionsdarstellung eines vierten Ausführungsbeispiels der Erfindung.

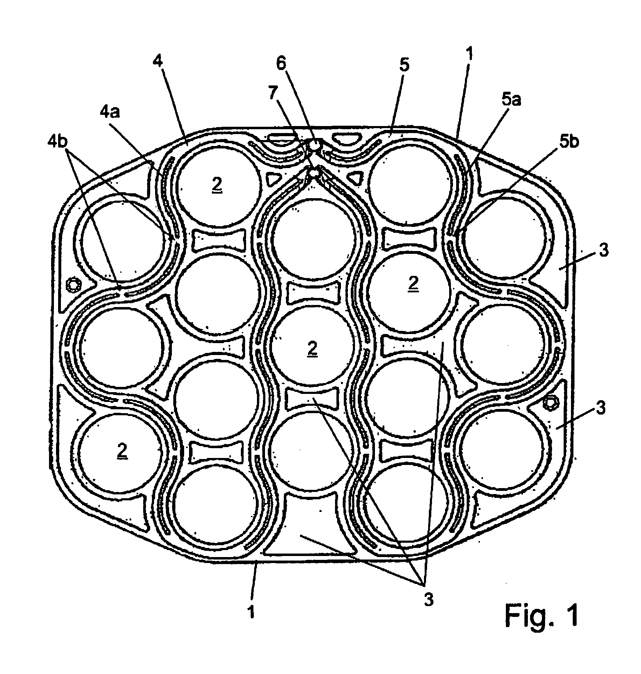

Das erste Ausführungsbeispiel der erfindungsgemäßen Vorrichtung gemäß Fig. 1 umfasst ein Plattenelement aus Aluminium 1, auf dem eine Mehrzahl von zylindrischen elektrischen Elementen 2 angeordnet sind. Die elektrischen Elemente 2 sind Lithium-lonen-Batterien, die mit ihren dem Kühlkörper 1 zugewandten Bodenflächen in einer Ebene angeordnet sind und an den Kühlkörper 1 jeweils elektrisch isoliert angrenzen. Hierzu sind ggf. Halteringe oder spiralförmige Umwicklungen aus Kunststoff (nicht dargestellt) zwischen dem Aluminium-Kühlkörper 1 und den elektrischen Elementen 2 angeordnet. Die Lithium-lonen-Batterien 2 haben eine dünne, metallisch leitende Außenwand, die mit einem der beiden Batteriepole verbunden ist. Auf jeder von zwei gegenüberliegenden Seiten des plattenförmigen Kühlkörpers 1 ist jeweils auf gleicher Weise die gleiche Anzahl elektrischer Elemente angeordnet. Vorliegend handelt es sich um insgesamt 34 elektrische Elemente, von denen je 17 auf jeder Seite des Kühlkörpers angeordnet sind. Jeweils zwei gegenüberliegende elektrische Elemente fluchten dabei mit ihren Symmetrieachsen. In dem Kühlkörper 1 ist zwischen diesen Elementenpaaren jeweils eine kreisförmige Durchbrechung (nicht dargestellt) vorgesehen, wodurch zum einen das Gesamtgewicht der Vorrichtung verringert wird und zum anderen ein Ausweichraum für bodenseitig der Elemente 2 vorgesehene Sollbruchstellen für den Fall des Versagens eines Elements geschaffen ist.

Zwischen den Elementen 2 ist auf jeder der Seiten des plattenförmigen Kühlkörpers 1 eine Anzahl von Leitkörpern 3 vorgesehen, die in ihrer Höhe über dem Kühlkörper 1 in etwa der Höhe der elektrischen Elemente 2 entsprechen. Die Leitkörper 3 bestehen aus Aluminium und sind mit dem Kühlkörper 1 verlötet, so dass ein guter thermischer Kontakt zwischen den Leitkörpern 3 und dem Kühlkörper 1 besteht. Die Leitkörper 3 weisen je nach ihrer Anordnung zwischen den elektrischen Elementen 2 unterschiedliche Querschnitte auf, wobei konkave Seitenflächen der Leitelemente 3 in den zylindrischen Außenwänden der elektrischen Elemente 2 in einem ausreichenden Sicherheitsabstand zur elektrischen Isolierung gegenüberliegen. Im vollständig montierten Zustand der Vorrichtung werden die Zwischenräume zwischen dem Leitkörper 3 und den elektrischen Elementen 2 mit einer Polymer-Vergussmasse aufgefüllt, die bevorzugt mit Keramikpulver zur Verbesserung ihrer thermischen Leitfähigkeit versetzt ist. Hierdurch ist jedes der elektrischen Elemente 2 zugleich in gutem thermischen Kontakt mit dem Kühlkörper 1 und den Leitkörpern 3 sowie elektrisch von diesen leitenden Bauteilen isoliert und mechanisch gesichert. Die Wärmeabfuhr von den zylindrischen Seitenwänden der Elemente 2 erfolgt zu einem erheblichen Anteil durch die Vergussmasse hindurch in die prismatischen oder stabförmigen Leitkörper3, in denen die Wärme in gemäß Fig. 1 senkrechter Richtung zu dem Kühlkörper geleitet wird.

Die elektrische Isolation weist eine Spannungsfestigkeit von zumindest etwa 1000 V auf. Zumindest einige der elektrischen Elemente 2 sind bei der Vorrichtung in Serie verschaltet, so dass trotz geringer Potentialdifferenzen der einzelnen Batterien recht hohe maximale Potentialdifferenzen zwischen einem elektrischen Element und dem Kühlkörper 1 auftreten können.

In dem Kühlkörper 1 sind mittels Fräsung ein erster Kanal 4 und ein zweiter Kanal 5 zur Führung eines Kühlmittels eingebracht, wobei die Kanäle 4, 5 in der Ebene des Kühlkörpers 1 und somit auch parallel zu den Bodenflächen der elektrischen Elemente 2 verlaufen. Die Kanäle 4, 5 verlaufen mit wechselnder Krümmungsrichtung abschnittsweise unmittelbar benachbart der Ränder der kreisförmigen Bodenflächen der Elemente 2, so dass die Wärmeabfuhr von den Elementen 2 verbessert ist.

Die Kanäle 4, 5 haben jeweils die gleiche Länge von etwa 650 mm. Ein gemeinsamer Eintritt 6 für das Kühlmittel und ein gemeinsamer Austritt 7 für das Kühlmittel ist jeweils endseitig der Kanäle 4, 5 vorgesehen. Die Kanäle 4, 5 haben über ihre gesamte Länge im Wesentlichen den gleichen Strömungsquerschnitt von insgesamt etwa 40 mm², wobei jeder der beiden Kanäle 4, 5 den gleichen Strömungsquerschnitt von etwa 20 mm² aufweist.

Vorliegend ist in der Mitte eines jeden der beiden Kanäle 4, 5 eine Rippe 4a, 5a vorgesehen, die über die gesamte Kanallänge durchgängig ist sondern etwa alle 100 mm eine Unterbrechung 4b, 5b zur Durchmischung von Kühlmittel der beiden Kanalseiten aufweist. Durch die Rippen 4a, 5a ist die thermische Kontaktfläche pro Kanallänge zwischen Kühlmittel und Kanalwand vergrößert.

Unter einem Kühlmittel im Sinne der Erfindung ist vorliegend jedes Wärme transportierende, fließfähige Fluid zu verstehen. Unter anderem kann es sich bei dem Kühlmittel um ein Kältemittel eines Kältekreises wie etwa einer Klimaanlage handeln.

In der schematischen Darstellung gemäß Fig. 1 ist eine obere Deckplatte der Kanäle 4, 5 bzw. des Kühlkörpers 1 nicht dargestellt. Bei der Herstellung des Kühlkörpers 1 kann diese Deckplatte mit dem dargestellten Plattenteil insbesondere flächig verlötet sein. Die Herstellung des Kühlkörpers 1 erfolgt zweckmäßig aus lotplattierten Aluminiumteilen, die nach entsprechenden Fertigungsschritten wie etwa Ausfräsen der Kanäle 4, 5, Aufsetzen der nicht dargestellten Deckplatte und Ansetzen der Leitkörper 3 zum Beispiel mittels Presssitz in geeigneten Bohrungen in vormontierter Anordnung insgesamt in einen Lötofen verbracht werden, um dort flächig miteinander verlötet zu werden.

Der Kühlkörper 1 ist mittels seines einlassseitigen Anschlusses 6 und seines auslassseitigen Anschlusses 7 an den Kältekreis einer Klimaanlage eines Personenkraftwagens mit Hybrid-Antrieb angeschlossen, wobei ein Elektromotor des Hybrid-Antriebs von den Lithium-lonen-Batterien 2 mit elektrischer Energie versorgt wird.

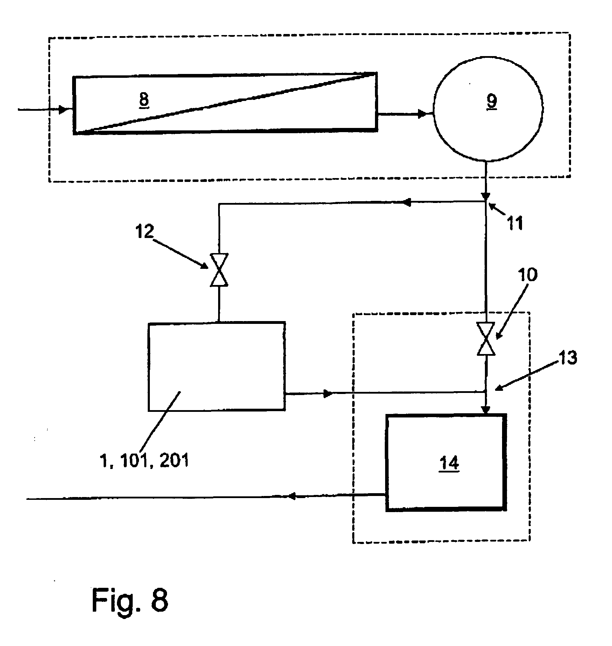

Die Integration des Kühlkörpers 1 in einen herkömmlichen Kältekreis mit dem Kältemittel R134a ist schematisch in Fig. 8 dargestellt. Der Kältekreis umfasst einen nicht dargestellten Verdichter, nachfolgend einen Kondensator 8 und einen mit diesem in Baueinheit integrierten Sammler 9. Eine Leitung führt von dem Sammler 9 zu einem Expansionsorgan 10 des Kältekreises, wobei ein Abzweig 11 vor dem Expansionsorgan 10 vorgesehen ist. Von dem Abzweig 11 führt eine Leitung zu einer Festdrossel 12, die ein eigenes Expansionsorgan des Kühlkörpers 1 darstellt. Von der Festdrossel 12 wird das Kältemittel zur Eintrittsöffnung 6 des Kühlkörpers 1 geführt, wonach es die beiden Kanäle 4, 5 durchläuft. Von der Austrittsöffnung 7 wird das Kältemittel zu einem Abzweig 13 des Kältekreises geführt, über den es unterhalb des Expansionsorgans 10 wieder in den Kältekreis einmündet. Dem Abzweig 13 ist auf bekannte Weise ein Verdampfer des Kältekreises nachgeordnet, über den zum Beispiel die Innenraumluft des Fahrzeugs konditionierbar ist.

Zweckmäßig sind der Abzweig 11, das Expansionsorgan 10 und der Abzweig 13 als bauliche Einheit ausgebildet, so dass der Kühlkörper 1 als zusätzliches Modul in bestehende Kältekreise integrierbar ist, wobei lediglich das Expansionsorgan mit den integrierten Abzweigen auszutauschen ist. Falls der Kältekreis des Kraftfahrzeugs eine CO₂-Klimaanalage ist (CO₂ bzw. R744 als Kältemittel), so erfolgt die Abzweigung des Kältemittels zu dem Kühlkörper in sinnvoller Ausführung nach einem inneren Wärmetauscher des CO₂-Kältekreises.

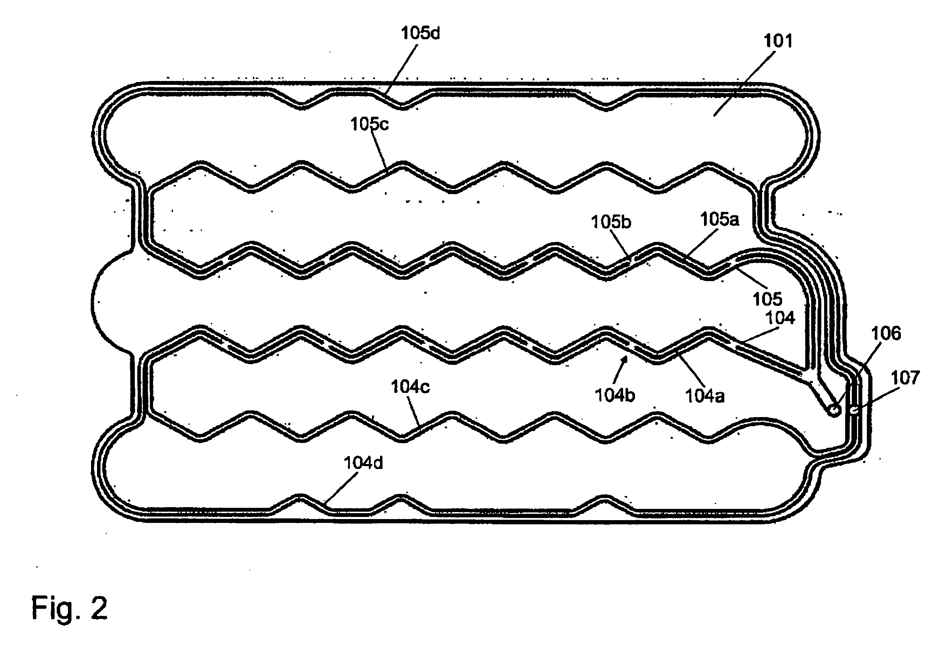

Bei dem zweiten Ausführungsbeispiel gemäß Fig. 2 ist ein Kühlkörper 101 vorgesehen, der im Unterschied zum ersten Ausführungsbeispiel nur auf einer Seite elektrische Elemente aufweist. Ein erster Kanal 104 und ein zweiter Kanal 105 verzweigen ausgehend von einem Einlass 106 für das Kältemittel. Zunächst verlaufen die Kanäle 104, 105 jeweils zickzackförmig über eine Längsrichtung des Kühlkörpers 101, wobei zwischen auf einer Höhe liegenden Zickzack-Abschnitten der Kanäle 104 und 105 jeweils ein elektrisches Element angeordnet ist (nicht dargestellt). Auf diesem ersten Abschnitt hat jeder der Kanäle 104, 105 ähnlich dem ersten Ausführungsbeispiel in seiner Mitte Rippenelemente 104a, 105a mit Unterbrechungen 104b, 105b zur Verbesserung des Wärmeaustauschs. Nach Durchlaufen des Kühlkörpers 101 entlang seiner Längsrichtung verzweigt jeder der Kanäle 104, 105 in einen ersten Teilkanal 104c, 105c und in einen zweiten Teilkanal 104d, 105d. Die Teilkanäle 104c, 104d, 105c, 105d laufen in korrepondierender Zickzack-Form längs des Kühlkörpers 101 zurück, wobei sie sich kurz vor ihrem Ende jeweils wieder zu einem gemeinsamen Kanal zusammenfügen und in einem gemeinsamen Auslass 107 für das Kältemittel münden.

Erkennbar ist die Kanalführung gemäß Fig. 2 so ausgelegt, dass in den geeigneten Zwischenräumen zwischen den zickzackförmigen Kanalverläufen insgesamt 33 zylindrische elektrische Elemente mit ihren dem Kühlkörper 101 zugewandten Bodenseiten angeordnet werden können, wobei im Wechsel jeweils eine Reihe mit 7 und eine Reihe mit 6 Elementen versetzt zueinander vorgesehen ist. Der Kühlkörper 101 des zweiten Ausführungsbeispiels ist somit zur Kühlung der annähernd gleichen Anzahl elektrischer Elemente ausgelegt wie der Kühlkörper 1 des ersten Ausführungsbeispiels.

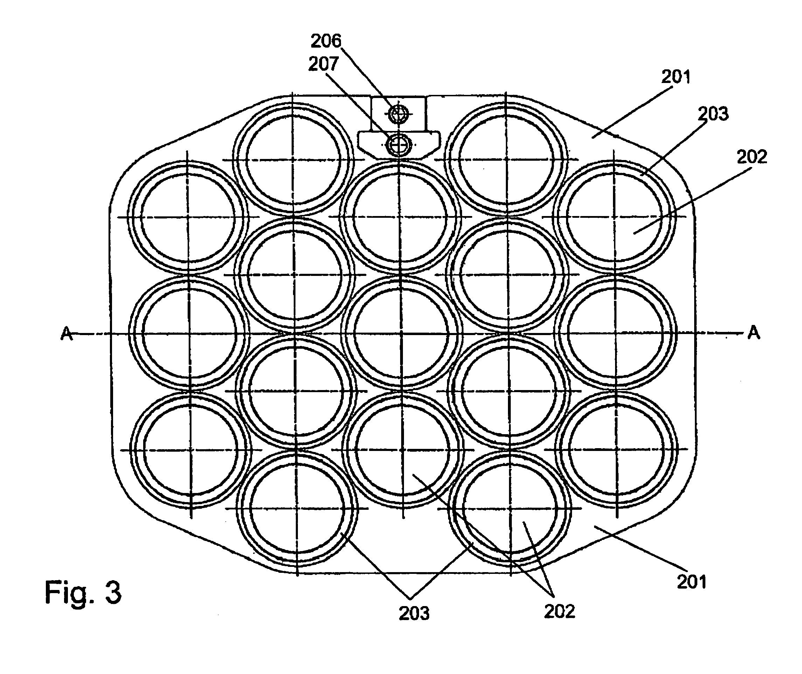

Das dritte Ausführungsbeispiel gemäß Fig. 3 ist hinsichtlich der räumlichen Anordnung der elektrischen Elemente 202 wie das erste Ausführungsbeispiel gemäß Fig. 1 ausgeführt. Ein Unterschied zu dem ersten Ausführungsbeispiel besteht darin, dass Leitkörper 203 im dritten Ausführungsbeispiel als zylindrische, becherförmige Wandungen ausgeformt sind, innerhalb derer jeweils ein elektrisches Element 202 angeordnet ist.

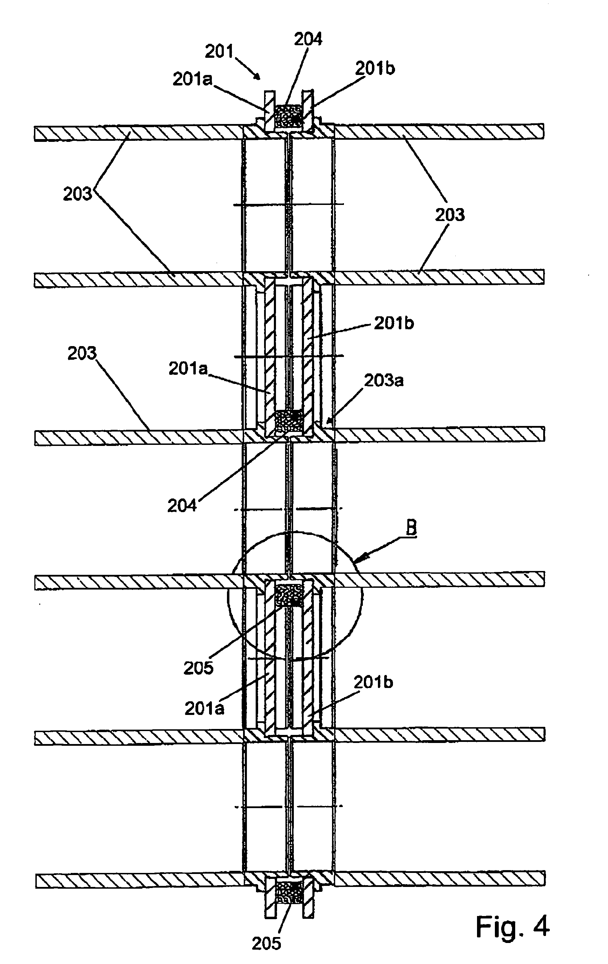

Wie die Schnittansicht gemäß Fig. 4 zeigt, umfasst der Kühlkörper 201 zwei parallele Aluminiumplatten 201a, 201b, durch die gegenüberliegende Seiten des Kühlkörpers 201 ausgebildet sind und die für jedes gegenüberliegende Paar von elektrischen Elementen 202 kongruente kreisförmige Durchbrechungen aufweisen.

Die Leitkörper 203 sind rotationssymmetrische Becherteile aus Aluminium, die mittels Abstufungen 203a in die kreisförmigen Durchbrechungen der Platten 201 a, 201b eingesetzt werden und mit den Rändern der Durchbrechungen flächig verlötet sind.

Zwischen den beiden Platten 201 a, 201 b sind zwei Mehrkammerrohre 204, 205 angeordnet, die in der Ebene der Platten bzw. der Bodenflächen der elektrischen Elemente mehrfach gebogen sind, so dass sie einen Verlauf in der Kühlkörperebene aufweisen, der dem Verlauf der Kanäle 4, 5 gemäß dem ersten Ausführungsbeispiel weitgehend entspricht.

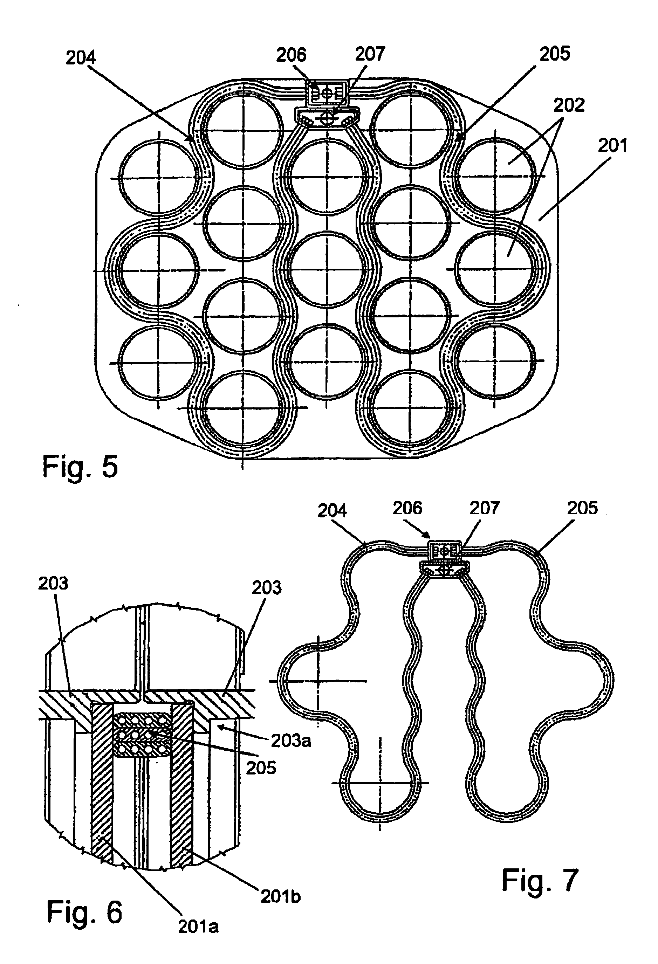

Jedes der Mehrkammerrohre 204, 205 ist gemäß der Darstellung in Fig. 4, Fig. 6 und Fig. 7 als Verbund von drei Strangpressprofil-Flachrohren ausgebildet, wobei in jedem der Strangpressprofile vier separate Kammern von kreisförmigem Querschnitt vorgesehen sind. Der Verbund dreier Flachrohre ermöglicht eine einfachere Biegung; alternativ kann zum Beispiel nur ein einzelnes Kanalrohr und auch eine andere Anordnung von darin vorgesehenen Kammern je nach Zweckmäßigkeit gegeben sein kann. Die Rohre müssen nicht notwendig Strangpressprofile sein.

Die Kanäle bzw. gebogenen Strangpressprofile 204, 205 sind jeweils einlassseitig über ein Anschlussstück 206 und auslassseitig über ein Anschlussstück 207 miteinander verbunden.

Die Herstellung des Kühlkörpers 201 des dritten Ausführungsbeispiels erfolgt ebenso wie im ersten Ausführungsbeispiel mittels lotplattierter Aluminiumteile, die zunächst mechanisch vormontiert werden und dann gemeinsam in einem Lötofen möglichst flächig miteinander verlötet werden. Insbesondere können die Plattenelemente 201a, 201b lotplattiert sein, wodurch wohl die Leitkörper 203 als auch die Kanalrohre 204, 205 verlötbar sind und zusätzliche Verfahrenschritte zur Lotplattierung dieser Bauteile 203, 204, 205 entfallen können.

Die elektrischen Elemente 202 sind im Fall des dritten Ausführungsbeispiels innerhalb der becherförmigen Leitkörper 203 angeordnet. Zweckmäßig können Abstandsringe aus elektrisch isolierendem Kunststoff oder Keramik zur Positionierung der elektrischen Elemente innerhalb der Becherteile vorgesehen sein, wobei zur Halterung der elektrischen Elemente und zur Sicherstellung einer elektrischen Isolierung ein verbleibender Zwischenraum zwischen den Becherleitkörpern 203 und den elektrischen Elementen 202 mittels einer Polymer-Vergussmasse vergossen wird.

Auch die Zwischenräume zwischen benachbarten Leitkörpern 203 können optional mit Vergussmasse vergossen werden, falls eine besonders gute Homogenisierung der Temperaturverteilung und der Kühlleistung über die Vorrichtung gewünscht ist.

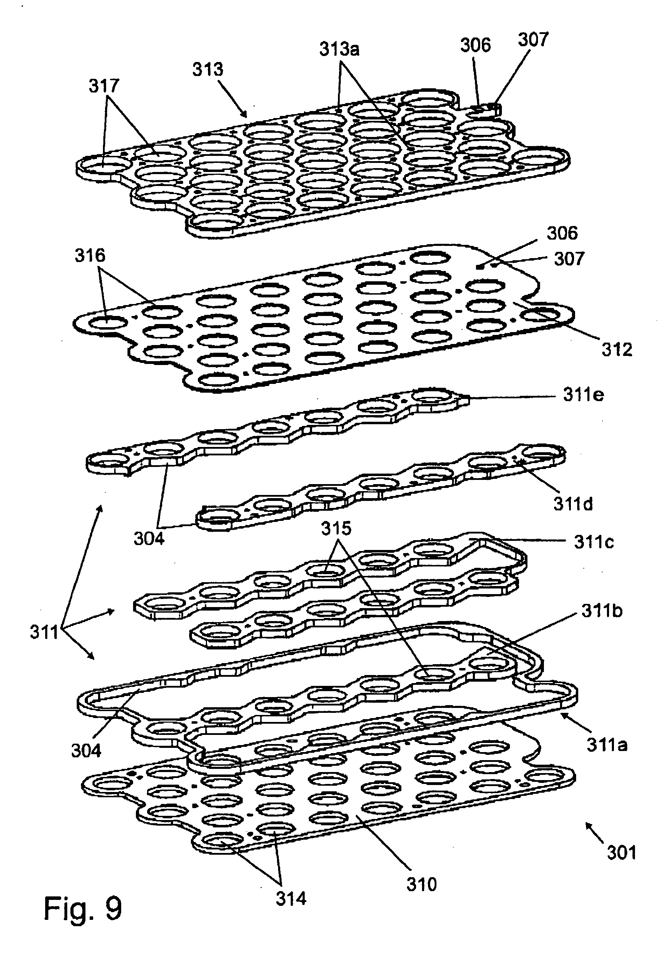

Ein weiteres Ausführungsbeispiel ist in Fig. 9 dargestellt. Der Kühlkörper 301 umfasst mehrere plattenförmige Elemente, nämlich eine untere Deckplatte 310, ein auf der unteren Deckplatte aufgebrachtes mittleres Plattenteil 311, eine auf dem mittleren Plattenteil aufgebrachte obere Deckplatte 312 und ein auf der oberen Deckplatte aufgebrachtes weiteres Plattenteil 313.

Das mittlere Plattenteil 311 besteht aus mehreren separaten Segmenten 311a bis 311e, die in der gleichen Ebene nebeneinander positioniert sind. Ein erstes Segment 311 a bildet eine geschlossene, umlaufende Berandung aus, wobei die anderen Segmente 311b bis 311e innerhalb dieser Berandung angeordnet sind zwischen den Rändern der Segmente 311a bis 311e verbleibt dabei eine Durchbrechung 304, durch die der Kanal zur Führung des Kühlmittels ausgebildet wird. Der Verlauf des Kanals 304 entspricht dabei im Wesentlichen derjenigen des Ausführungsbeispiels aus Fig. 2. Ebenso entspricht die Anordnung und Anzahl der elektrischen Elemente (nicht dargestellt) diesem Ausführungsbeispiel.

Durch die Anordnung der oberen und unteren Deckplatten 310, 312 werden die Durchbrechungen 304 überdeckt und so zum Kühlmittelkanal geschlossen.

Sowohl das mittlere Plattenteil 311 als auch die Deckplatten 310, 312 haben zudem eine Anzahl kreisförmiger, miteinander fluchtender Durchbrechungen 314, 315, 316. Durch diese Durchbrechungen werden Ausweichräume oder Berstöffnungen bereitgestellt, in die hinein die elektrischen Elemente im Falle einer entsprechenden Fehlfunktion aufplatzen können. Die elektrischen Elemente sind mit ihren Bodenflächen über den Berstöffnungen angeordnet, wobei die Bodenflächen mit einer Sollbruchstelle versehen sind. Zudem verläuft innerhalb der Elemente eine Kontaktierung im Bereich der Sollbruchstelle, so dass ein hitze- bzw. druckbedingtes Bersten des Bodens zugleich zu einer Stromkreisunterbrechung des betroffenen Elements führt. Zudem bedeuten die Durchbrechungen 314, 315, 316 eine Verringerung des Gewichts des Kühlkörpers.

Auf der oberen Deckplatte 312 ist ein weiteres Plattenteil 313 flächig angeordnet, das eine entsprechende Menge kongruenter kreisförmiger Durchbrechungen 317 aufweist. Der Durchmesser der Durchbrechungen 317 ist etwas größer als der der anderen Durchbrechungen 314, 315 und 316, da das weitere Plattenteil 313 nicht die Kühlmittelkanäle 304 überdecken muss.

Das weitere Plattenteil 313 ist etwas dicker als die obere Deckplatte 312 und hat eine Reihe von Bohrungen 313a zur Aufnahme von Leitkörpern (nicht dargestellt). Diese Leitkörper sind prismatisch und erstrecken sich senkrecht zu der Ebene des Kühlkörpers 301. Sie sind zwischen den elektrischen Elementen angeordnet und verbessern die Wärmeableitung von den Elementen zum Kühlkörper. Die nicht dargestellten Leitkörper entsprechen grundsätzlich den Leitkörpern 3 des ersten Ausführungsbeispiels (Fig. 1).

Zum Anschluss an eine Zuleitung und Ableitung des Kühlmittels weisen die obere Deckplatte 312 und das weitere Plattenteil 313 jeweils fluchtende Bohrungen 306, 307 auf, die jeweils mit entgegengesetzten Enden des Kanals 304 verbunden sind (ähnlich den Anschlüssen 106, 107 in Fig. 2).

Sämtliche der plattenförmigen Teile 310, 311, 312, 312 sowie die nicht dargestellten Leitkörper bestehen aus einer Aluminiumlegierung. Das mittlere Plattenteil 311 ist beidseitig lotplattiert und das weitere Plattenteil 313 ist zumindest auf seiner der oberen Deckplatte zugewandten Seite lotplattiert. Zur Festlegung der Leitkörper sind auch die Leitkörper und/oder die den Leitkörpern zugewandte Seite des weiteren Plattenteils 313 lotplattiert. Hierdurch kann die Vorrichtung einfach hergestellt werden, indem die Teile mechanisch zueinander positioniert werden, zum Beispiel durch klammemde Halterung, und nachfolgend in einem Lötofen flächig miteinander verlötet werden.

Das mittlere Plattenteil hat typisch eine Dicke von rund 5 mm, wobei seine Länge etwa 60 cm und seine Breite etwa 30 cm beträgt. Die Abbildung Fig. 9 ist im Wesentlichen maßstabsgerecht. Die Durchbrechungen bzw. ihre Ränder 304, 315, 314, 316, 317 können auf verschiedene Weise hergestellt werden, zum Beispiel durch Laserschneiden oder durch Stanzen. Es kann ein mehrstufiger Stanzvorgang angewendet werden, um gegebenenfalls einer entsprechenden Dicke des plattenförmigen Teils Rechnung zu tragen. Es kann insbesondere vorgesehen sein, dass die Durchbrechungen in den dünneren Deckplatten 310, 312 durch Stanzen hergestellt werden und dass die Durchbrechungen in zumindest einer der dickeren Platten 311, 313 durch Laserschneiden oder ein anderes geeignetes Formungsverfahren hergestellt werden.

Nach der zuvor beschriebenen Herstellung des vorliegend vollständig aus Leichtmetall bestehenden Kühlkörpers 301 werden die elektrischen Elemente angeordnet und festgelegt. Hierzu werden die (nicht dargestellten), vorliegend zylindrischen Elemente durch geeignete Haltevorrichtung mit kleinem Abstand ihrer Bodenflächen vor dem obersten Plattenteil 313 und zwischen den Leitkörpern positioniert, wobei an keiner Stelle eine Berührung stattfindet. Dann wird ähnlich wie im ersten Ausführungsbeispiel eine elektrisch isolierende und thermisch leitfähige Vergussmasse aufgebracht, die den Raum zwischen den elektrischen Elementen einerseits und dem Kühlkörper 301 andererseits auffüllt. Die kreisförmigen Berstöffnungen werden dabei nicht verfüllt.

Es versteht sich, dass der Kühlkörper ähnlich wie in Fig. 4 beidseitig elektrische Elemente aufweisen kann. Hierzu könnte eine weitere, dem Plattenteil 313 entsprechende Platte mit Leitkörpern auf der unteren Deckplatte 310 angeordnet sein.

Sämtliche der beschriebenen Ausführungsbeispiele sind gemäß Fig. 1 bis Fig. 7 und Fig. 9 sind zweckmäßig mit ihren Kühlmittelanschlüssen mit einer Klimaanlage eines Kraftfahrzeugs verbunden, wobei die zuvor beschriebene und in Fig. 8 dargestellte Parallelschaltung besonders zweckmäßig ist. Über ein nicht dargestelltes Schaltventil, zum Beispiel ein getaktetes Magnetventil, kann eine Verteilung der Kältemittelströme zwischen dem Kühlkörper und einem üblichen Verdampfer der Klimaanlage beeinflusst werden.

Alternativ kann für die Vorrichtung auch ein eigener Kältekreis vorgesehen sein, der von einer Klimaanlage des Kraftfahrzeugs unabhängig arbeitet.

Zur optimalen Anbindung an einen Kältekreis haben die Kanäle jeweils eine optimierte Länge und einen optimierten Strömungsquerschnitt. Dies führt dazu, dass ein Kältemittelstrom eines typischen für einen Personenkraftwagen dimensionierten Kältekreises die Kanäle so durchströmt, dass bei maximaler Abfrage von Kühlleistung durch die elektrischen Elemente eine vollständige Verdampfung ohne übermäßige Überhitzung auftritt. Falls keine oder nur wenig Kühlleistung durch die elektrischen Elemente benötigt wird, so kann das Kältemittel durchaus ohne oder mit nur geringer Verdampfung die Kanäle durchströmen, wonach es einer Verdampfung in einem Verdampfer der Klimaanlage des Fahrzeugs noch zur Verfügung steht.

Hierzu werden die Kanäle insbesondere mit einem homogenen Strömungsquerschnitt ausgebildet und nicht durchströmte Seitenarme oder Ausbuchtungen werden vermieden, welche als Fallen für das im Klimakreis umlaufende Öl wirken könnten. Die vorgestellten Ausführungsformen mit den genannten Kanalabmessungen sind im Falle der Verwendung des Kältemittels R134a bei Kombination mit typischen Klimaanlagen für Personenkraftwagen sämtlich so ausgelegt, dass der gesamte Massenstrom des Kältemittels etwa 4 bis 5 g/s beträgt. Dies ergibt bei praxisgerechter Nutzung der Verdampfungswärme eine Wärmeabfuhr von etwa 400 bis 500 W. Bei den gegebenen summierten Strömungsquerschnitten der Kanäle von etwa 40 mm² kann eine Massenstromdichte von etwa 120 kg/m²s erreicht werden. Diese Massenstromdichte liegt etwa 50% oberhalb einer experimentell ermittelten unteren Grenze zur Gewährleistung der gewünschten Wärmeabfuhr. Dieser Überschuss an Massenstromdichte von Kältemittel wird unter anderem aus dem Grund eingeführt, dass die gewünschte minimale Kühlleistung möglichst unabhängig von der räumlichen Lage der Vorrichtung bzw. ungünstiger Einflüsse der Schwerkraft auf den Kältemittelstrom erzielt wird.

Es versteht sich, dass die besonderen Merkmale der verschiedenen Ausführungsbeispiele zwanglos miteinander kombiniert werden können.

## Patentansprüche

1. Vorrichtung zur Kühlung elektrischer Elemente, umfassend
einen von einem Kühlmittel durchströmbaren Kühlkörper (1, 101, 201),
eine Mehrzahl von elektrischen Elementen (2, 202), die jeweils eine Bodenfläche und eine Seitenfläche aufweisen, wobei die Bodenflächen im Wesentlichen in einer Ebene ausgerichtet sind,
wobei der Kühlkörper (1, 101, 201) zumindest einen von einem Kühlmittel durchströmbaren Kanal (4, 5, 104, 105, 204, 205) aufweist und in thermischem Kontakt mit den elektrischen Elementen (2, 202) steht, wobei der Kühlkörper (1, 101, 201) sich im Wesentlichen parallel zu der Ebene der Bodenflächen erstreckt, wobei der Kanal (4, 5, 104, 105, 204, 205) in dem Kühlkörper einen Verlauf aufweist, der an Berandungen der elektrischen Elemente (2, 202) angepasst ist, **dadurch gekennzeichnet, dass** der Kühlkörper (301) als Stapel aus einer Mehrzahl von plattenförmigen Elementen (310, 311, 312, 313) ausgebildet ist, wobei der Stapel ein mittleres Plattenteil (311) umfasst, wobei das mittlere Plattenteil eine Durchbrechung (304) zur Ausbildung des Kanals aufweist und auf dem mittleren Plattenteil zumindest eine Deckplatte (310, 312) zur Ausbildung des Kanals dichtend festgelegt ist und auf der dem mittleren Plattenteil (311) gegenüberliegenden Seite der Deckplatte (312) ein weiteres Plattenteil (313) festgelegt ist.

2. Vorrichtung nach Anspruch 1, **dadurch gekennzeichnet, dass** die Bodenflächen der elektrischen Elemente (2, 202) an den Kühlkörper (1, 101, 201) angrenzen.

3. Vorrichtung nach Anspruch 1 oder 2, **dadurch gekennzeichnet, dass** der Kühlkörper (1, 101, 201) zwei gegenüberliegende Seiten aufweist, wobei auf jeder der Seiten eine Mehrzahl elektrischer Elemente (2, 202) aufgenommen ist.

4. Vorrichtung nach einem der vorhergehenden Ansprüche, **dadurch gekennzeichnet, dass** die elektrischen Elemente (2, 202) gegenüber dem Kühlkörper (1, 101, 201) elektrisch isoliert sind.

5. Vorrichtung nach einem der vorhergehenden Ansprüche, **dadurch gekennzeichnet, dass** den elektrischen Elementen benachbarte Leitkörper (3, 203) an dem Kühlkörper (1, 201) angeordnet sind, wobei sich die Leitkörper (3, 203) im Wesentlichen senkrecht zu dem Kühlkörper (1, 201) erstrecken und in thermischem Kontakt mit den elektrischen Elementen stehen.

6. Vorrichtung nach Anspruch 5, **dadurch gekennzeichnet, dass** die Leitkörper (3, 203) stoffschlüssig, insbesondere durch Verlötung, mit dem Kühlkörper (1, 101, 201) verbunden sind.

7. Vorrichtung nach Anspruch 5 oder 6, **dadurch gekennzeichnet, dass** zumindest einige der Leitkörper (203) als Becher mit einer zumindest teilweise umlaufenden Wand ausgebildet sind, wobei jeweils ein elektrisches Element (202) in einem der becherförmigen Leitkörper (203) aufgenommen ist.

8. Vorrichtung nach einem der Ansprüche 5 bis 7, **dadurch gekennzeichnet, dass** zumindest einige der Leitkörper (3) jeweils als ein zwischen benachbarten elektrischen Elementen (2) angeordneter Stab ausgebildet sind.

9. Vorrichtung nach einem der Ansprüche 5 bis 8, **dadurch gekennzeichnet, dass** die elektrischen Elemente (2, 202) stoffschlüssig, insbesondere mittels einer die Elemente einhüllenden Vergussmasse, mit den Leitkörpern verbunden sind.

10. Vorrichtung nach einem der vorhergehenden Ansprüche, **dadurch gekennzeichnet, dass** die elektrischen Elemente (2, 102, 202) im wesentlichen die Form eines Zylinders aufweisen, wobei eine Stirnfläche des Zylinders der Bodenfläche des elektrischen Elements (2, 102, 202) entspricht.

11. Vorrichtung nach einem der vorhergehenden Ansprüche, **dadurch gekennzeichnet, dass** die Berandungen der elektrischen Elemente (2, 202) Rändern der Bodenfläche der Elemente (2, 202) entsprechen, wobei der Kanal (4, 5, 104, 105, 204, 205) zumindest abschnittsweise benachbart der Ränder mehrerer Elemente (2, 202) verläuft.

12. Vorrichtung nach Anspruch 11, **dadurch gekennzeichnet, dass** der Kanal (4, 5, 104, 105, 204, 205) nacheinander Abschnitten der Ränder mehrerer Elemente folgt, wobei eine Richtung des Kanals sich alternierend mit den nacheinander folgenden Elementen ändert.

13. Vorrichtung nach Anspruch 11 oder 12, **dadurch gekennzeichnet, dass** der Verlauf des Kanals (4, 5, 204, 205) entlang der Ränder im Wesentlichen teilkrelsförmig ist.

14. Vorrichtung nach Anspruch 11 oder 12, **dadurch gekennzeichnet, dass** der Kanal (104, 105) einen im Wesentlichen zickzackförmigen Verlauf aufweist.

15. Vorrichtung nach einem der vorhergehenden Ansprüche, **dadurch gekennzeichnet, dass** der Kanal (104, 105) sich in seinem Verlauf in zumindest zwei Teilkanäle (104c, 104d, 105c, 105d) verzweigt.

16. Vorrichtung nach Anspruch 15, **dadurch gekennzeichnet, dass** die zumindest zwei Teilkanäle (104c, 104d, 105c, 105d) in der Summe etwa den gleichen Strömungsquerschnitt aufweisen wie der unverzweigte Kanal (104, 105).

17. Vorrichtung nach einem der vorhergehenden Ansprüche, **dadurch gekennzeichnet, dass** der Kanal (4, 5, 104, 105) als Einfräsung in einem plattenartigen Metallteil, insbesondere aus Aluminium, ausgebildet ist.

18. Vorrichtung nach einem der Ansprüche 1 bis 16, **dadurch gekennzeichnet, dass** der Kanal (204, 205) als gebogenes Rohr, insbesondere als Strangpressprofil mit mehreren Kammern, ausgebildet ist.

19. Vorrichtung nach einem der vorhergehenden Ansprüche, **dadurch gekennzeichnet, dass** der Kühlkörper (1, 101, 201) zumindest zwei insbesondere parallel geschaltete Kanäle (4, 5, 104, 105, 204, 205) umfasst.

20. Vorrichtung nach Anspruch 19, **dadurch gekennzeichnet, dass** die zumindest zwei Kanäle (4, 5, 104, 105, 204, 205) im Wesentlichen die gleiche Länge aufweisen.

21. Vorrichtung nach Anspruch 20, **dadurch gekennzeichnet, dass** die Länge des zweiten Kanals (5, 105, 205) von der Länge des ersten Kanals (4, 104, 204) um nicht mehr als etwa 40%, insbesondere um nicht mehr als etwa 20% abweicht.

22. Vorrichtung nach einem der Ansprüche 19 bis 21, **dadurch gekennzeichnet, dass** die zumindest zwei Kanäle (4, 5, 104, 105, 204, 205) jeweils einen im wesentlichen konstanten Strömungsquerschnitt von im wesentlichen gleicher Größe aufweisen.

23. Vorrichtung nach Anspruch 22, **dadurch gekennzeichnet, dass** der Strömungsquerschnitt des zweiten Kanals (5, 105, 205) sich von dem Strömungsquerschnitt des ersten Kanals (4, 104, 204) um nicht mehr als etwa 30%, insbesondere um nicht mehr als etwa 15% unterscheidet.

24. Vorrichtung nach einem der vorhergehenden Ansprüche, **dadurch gekennzeichnet, dass** die elektrischen Elemente (2, 102, 202) Akkumulatoren, insbesondere Lithium-lonen-Batterien, sind.

25. Vorrichtung nach einem der vorhergehenden Ansprüche, **dadurch gekennzeichnet, dass** der Kühlkörper (1, 101, 201) an einen Kältekreis einer Klimaanlage eines Kraftfahrzeugs angeschlossen ist, wobei das Kühlmittel ein Kältemittel der Klimaanlage ist.

26. Vorrichtung nach Anspruch 25, **dadurch gekennzeichnet, dass** das Kältemittel R134a ist.

27. Vorrichtung nach Anspruch 25 oder 26, **dadurch gekennzeichnet, dass** der Kühlkörper (1, 101, 201) in Parallelschaltung in dem Kältekreis angeordnet ist.

28. Vorrichtung nach Anspruch 27, **dadurch gekennzeichnet, dass** eine Zuführung (11) des Kältemittels nach einem Sammler (9) und insbesondere vor einem Expansionsorgan (10) des Kältekreises abzweigt.

29. Vorrichtung nach Anspruch 27 oder 28, **dadurch gekennzeichnet, dass** eine Abführung (13) des Kältemittels von dem Kühlkörper vor einem Verdampfer (14) des Kältekreises und insbesondere nach einem Expansiortsorgan (10) des Kältekreises einmündet.

30. Vorrichtung nach einem der Ansprüche 25 bis 29, **dadurch gekennzeichnet, dass** vor dem Kühlkörper (1, 101, 201) ein Expansionsorgan (12) seriell zu dem Kühlkörper angeordnet ist, wobei das Expansionsorgan (12) insbesondere als Festdrossel ausgebildet ist.

31. Vorrichtung nach einem der Ansprüche 27 bis 30, **dadurch gekennzeichnet, dass** eine Zuführung zu dem Kühlkörper (1, 101, 201) und eine Einmündung von dem Kühlkörper jeweils in einem Expansionsorgan (10) des Kältekreises baulich integriert sind.

32. Vorrichtung nach einem der Ansprüche 25 bis 31, **dadurch gekennzeichnet, dass** der Kältemittelstrom durch den Kühlkörper (1, 101, 201) über ein ansteuerbares Ventil veränderbar ist.

33. Vorrichtung nach einem der Ansprüche 25 bis 32, **dadurch gekennzeichnet, dass** der Kanal (4, 5, 104, 105, 204, 205) eine Länge von weniger als etwa 1000 mm, insbesondere von etwa 650 mm aufweist.

34. Vorrichtung nach einem der Ansprüche 25 bis 33, **dadurch gekennzeichnet, dass** der Kanal (4, 5, 104, 105, 204, 205) einen Strömungsquerschnitt zwischen etwa 5 mm² und etwa 170 mm² aufweist, insbesondere zwischen etwa 30 mm² und etwa 50 mm².

35. Vorrichtung nach einem der Ansprüche 25 bis 34, **dadurch gekennzeichnet, dass** ein totaler Kältemittelstrom durch den Kühlkörper zwischen etwa 4 g/s und etwa 5 g/s beträgt.

36. Vorrichtung nach einem der vorhergehenden Ansprüche, **dadurch gekennzeichnet, dass** das mittlere Plattenteil (311) zumindest zwei separate, nicht einstückig ausgebildete Segmente (311 a, 311b, 311c, 311d, 311e) umfasst.

37. Vorrichtung nach einem der vorhergehenden Ansprüche, **dadurch gekennzeichnet, dass** das mittlere Plattenteil (311) zudem eine Mehrzahl von insbesondere kreisförmigen Durchbrechungen (314) aufweist, wobei diese Durchbrechungen in Überdeckung mit den Bodenflächen der elektrischen Elementen angeordnet sind.

38. Vorrichtung nach einem der vorhergehenden Ansprüche, **dadurch gekennzeichnet, dass** mittleres Plattenteil (311) und Deckplatte (310, 312) flächig miteinander verlötet sind.

39. Vorrichtung nach einem der vorhergehenden Ansprüche, **dadurch gekennzeichnet, dass** zumindest einige der plattenförmigen Elemente (310, 311, 312, 313) eine flächige Lotplattierung aufweisen.

40. Vorrichtung nach einem der vorhergehenden Ansprüche, **dadurch gekennzeichnet, dass** die plattenförmigen Elemente (310, 311, 312, 313) aus einer Leichtmetalllegierung, insbesondere auf Basis von Aluminium, bestehen.

41. Verfahren zur Herstellung einer Vorrichtung nach einem der Ansprüche 1 bis 40, umfassend die Schritte
a. Einbringen einer Durchbrechung (304) in ein mittleres Plattenteil (311), wobei die Durchbrechung (304) dem Verlauf des Kanals entspricht;
b. Anordnen eines ersten und eines zweiten plattenförmigen Deckelteils (310, 312) auf dem mittleren Plattenteil (311) zur Ausbildung des Kanals;
c. dichtendes Festlegen der plattenförmigen Deckelteile (310, 312) an dem mittleren Plattenteil (311)
d Festlegen eines weiteren Plattenteils (313) auf der dem mittleren Plattenteil (311) gegenüberliegenden Seite mindestens eines der Deckelteile (310,312).

42. Verfahren nach Anspruch 41, **dadurch gekennzeichnet, dass** Schritt c. ein flächiges Verlöten der Deckelteile (310, 312) an dem mittleren Plattenteil (311) umfasst, insbesondere durch Einbringen der aufeinander angeordneten plattenförmigen Teile in einen Lötofen.

43. Verfahren nach Anspruch 41 oder 42, **dadurch gekennzeichnet, dass** die Durchbrechung (304) des mittleren Plattenteils (311) mittels Laserschneiden eingebracht wird.

44. Verfahren nach Anspruch 41 oder 42, **dadurch gekennzeichnet, dass** die Durchbrechung (304) des mittleren Plattenteils (311) mittels Stanzen eingebracht wird.

45. Verfahren nach einem der Ansprüche 41 bis 44, **gekennzeichnet durch** den Schritt
e. Anbringen einer Mehrzahl von sich im Wesentlichen senkrecht zu dem mittleren Plattenteil (311) erstreckenden Leitkörpern, insbesondere mittels Verlöten.

46. Verfahren nach einem der Ansprüche 41 bis 45, **gekennzeichnet durch** den Schritt
f. Positionieren der elektrischen Elemente relativ zu dem Kühlkörper (301) und Aufbringen einer Vergussmasse zwischen den Elementen und dem Kühlkörper (301).

47. Kraftfahrzeug, insbesondere Personenkraftwagen, umfassend
zumindest einen Elektromotor zum Fahrantrieb des Kraftfahrzeugs, und
eine Vorrichtung nach einem der Ansprüche 1 bis 40,
wobei der Elektromotor seine Antriebsenergie zumindest teilweise aus den elektrischen Elementen (2, 102, 202) bezieht.

48. Kraftfahrzeug nach Anspruch 47, dadurch gekenntzeichnet, dass das Kraftfahrzeug einen Hybrid-Antrieb aus dem Elektromotor und einem Verbrennungsmotor aufweist.

## Claims

1. A device for cooling electrical elements, comprising:
a heat sink (1, 101, 201) through which a coolant can flow;
a plurality of electrical elements (2, 202), which each have a bottom surface and a lateral surface, wherein the bottom surfaces are substantially aligned in one plane;
wherein the heat sink (1, 101, 201) comprises at least one channel (4, 5, 104, 105, 204, 205) through which a coolant can flow and the heat sink is in thermal contact with the electrical elements (2, 202), wherein the heat sink (1, 101, 201) extends substantially parallel to the plane of the bottom surfaces, wherein the course of the channel (4, 5, 104, 105, 204, 205) in the heat sink is adapted to the boundaries of the electrical elements (2, 202),
**characterized in that** the heat sink (301) is designed as a stack of a plurality of plate-shaped elements (310, 311, 312, 313), wherein the stack comprises a center plate part (311), wherein the center plate part comprises an aperture (304) so as to form the channel, and at least one cover plate (310, 312) is sealingly fixed on the center plate part so as to form the channel, and an additional plate part (313) is fixed on the side of the cover plate (312) that is located opposite the center plate part (311).

2. The device according to claim 1, **characterized in that** the bottom surfaces of the electrical elements (2, 202) adjoin the heat sink (1, 101, 201).

3. The device according to claim 1 or 2, **characterized in that** the heat sink (1, 101, 201) has two opposing sides, wherein a plurality of electrical elements (2, 202) is received on each of the sides.

4. A device according to any one of the preceding claims, **characterized in that** the electrical elements (2, 202) are electrically insulated with respect to the heat sink (1, 101, 201).

5. A device according to any one of the preceding claims, **characterized in that** guide bodies (3, 203) that are located adjacent to the electrical elements are arranged on the heat sink (1, 201), wherein the guide bodies (3, 203) extend substantially perpendicular relative to the heat sink (1, 201) and are in thermal contact with the electrical elements.

6. The device according to claim 5, **characterized in that** the guide bodies (3, 203) are bonded to the heat sink (1, 101, 201), in particular by way of soldering.

7. The device according to claim 5 or 6, **characterized in that** at least some of the guide bodies (203) are designed as cups having a respective circumferential wall at least in some sections, wherein each electrical element (202) is received in one of the cup-shaped guide bodies (203).

8. A device according to any one of claims 5 to 7, **characterized in that** at least some of the guide bodies (3) are designed in each case as a rod that is arranged between adjacent electrical elements (2).

9. A device according to any one of claims 5 to 8, **characterized in that** the electrical elements (2, 202) are bonded to the guide bodies, in particular by way of a potting compound that envelopes the elements.

10. A device according to any one of the preceding claims, **characterized in that** the electrical elements (2, 102, 202) are substantially cylindrical, wherein an end face of the cylinder corresponds to the bottom surface of the electrical elements (2, 102, 202).

11. A device according to any one of the preceding claims, **characterized in that** the boundaries of the electrical elements (2, 202) correspond to edges of the bottom surfaces of the elements (2, 202), wherein the channel (4, 5, 104, 105, 204, 205) runs adjacent to the edges of several elements (2, 202) at least in some sections.

12. The device according to claim 11, **characterized in that** the channel (4, 5, 104, 105, 204, 205) successively follows sections of the edges of several elements, wherein a direction of the channel changes alternately with the successive elements.

13. The device according to claim 11 or 12, **characterized in that** the course of the channel (4, 5, 204, 205) essentially has a circular segment shape along the edges.

14. The device according to claim 11 or 12, **characterized in that** the channel (104, 105) has a substantially zigzag-shaped course.

15. A device according to any one of the preceding claims, **characterized in that** the channel (104, 105) branches over the course thereof into at least two sub-channels (104c, 104d, 105c, 105d).

16. The device according to claim 15, **characterized in that**, in sum, the at least two sub-channels (104c, 104d, 105c, 105d) have approximately the same flow cross-section as the unbranched channel (104, 105).

17. A device according to any one of the preceding claims, **characterized in that** the channel (4, 5, 104, 105) is designed as a milled recess in a plate-like metal part, in particular made of aluminum.

18. A device according to any one of claims 1 to 16, **characterized in that** the channel (204, 205) is designed as a curved tube, in particular as a profiled extruded section having a plurality of chambers.

19. A device according to any one of the preceding claims, **characterized in that** the heat sink (1, 101, 201) comprises at least two channels (4, 5, 104, 105, 204, 205), which are in particular connected in parallel.

20. The device according to claim 19, **characterized in that** the at least two channels (4, 5, 104, 105, 204, 205) have substantially the same length.

21. The device according to claim 20, **characterized in that** the length of the second channel (5, 105, 205) deviates from the length of the first channel (4, 104, 204) by no more than approximately 40%, and more particularly by no more than approximately 20%.

22. A device according to any one of claims 19 to 21, **characterized in that** each of the at least two channels (4, 5, 104, 105, 204, 205) has a substantially constant flow cross-section of essentially the same size.

23. The device according to claim 22, **characterized in that** the flow cross-section of the second channel (5, 105, 205) deviates from the flow cross-section of the first channel (4, 104, 204) by no more than approximately 30%, and more particularly by no more than approximately 15%.

24. A device according to any one of the preceding claims, **characterized in that** the electrical elements (2, 102, 202) are rechargeable batteries, in particular lithium-ion batteries.

25. A device according to any one of the preceding claims, **characterized in that** the heat sink (1, 101, 201) is connected to a cooling circuit of an air conditioning system of a motor vehicle, wherein the coolant is a refrigerant of the air conditioning system.

26. The device according to claim 25, **characterized in that** the refrigerant is R134a.

27. The device according to claim 25 or 26, **characterized in that** the heat sink (1, 101, 201) is connected in parallel in the refrigeration circuit.

28. The device according to claim 27, **characterized in that** an inlet (11) for the refrigerant branches off downstream of a header (9), and in particular upstream of an expansion valve (10) of the refrigeration circuit.

29. The device according to claim 27 or 28, **characterized in that** an outlet (13) for the refrigerant from the heat sink leads in upstream of an evaporator (14) of the refrigeration circuit, and in particular downstream of an expansion valve (10) of the refrigeration circuit.

30. A device according to any one of claims 25 to 29, **characterized in that** an expansion valve (12) is arranged in series to the heat sink upstream of the heat sink (1, 101, 201), wherein the expansion valve (12) is designed in particular as a fixed restrictor.

31. A device according to any one of claims 27 to 30, **characterized in that** an inlet to the heat sink (1, 101, 201) and a mouth from the heat sink are each structurally integrated in an expansion valve (10) of the refrigeration circuit.

32. A device according to any one of claims 25 to 31, **characterized in that** the refrigerant flow through the heat sink (1, 101, 201) can be varied by way of a controllable valve.

33. A device according to any one of claims 25 to 32, **characterized in that** the channel (4, 5, 104, 105, 204, 205) has a length of less than approximately 1000 mm, and more particularly of approximately 650 mm.

34. A device according to any one of claims 25 to 33, **characterized in that** the channel (4, 5, 104, 105, 204, 205) has a flow cross-section between approximately 5 mm² and approximately 170 mm², and more particularly between approximately 30 mm² and approximately 50 mm².

35. A device according to any one of claims 25 to 34, **characterized in that** a total refrigerant flow through the heat sink is between approximately 4 g/s and approximately 5 g/s.

36. A device according to any one of the preceding claims, **characterized in that** the center plate part (311) comprises at least two separate, not integrally designed segments (311a, 311b, 311c, 311d, 311e).

37. A device according to any one of the preceding claims, **characterized in that** the center plate part (311) additionally comprises a plurality of in particular circular apertures (314), wherein these apertures are arranged so as to be superimposed on the bottom surfaces of the electrical elements.

38. A device according to any one of the preceding claims, **characterized in that** the center plate part (311) and cover plate (310, 312) are soldered to each other in a planar manner.

39. A device according to any one of the preceding claims, **characterized in that** at least some of the plate-shaped elements (310, 311, 312, 313) comprise an areal solder plating.

40. A device according to any one of the preceding claims, **characterized in that** the plate-shaped elements (310, 311, 312, 313) are made of a light metal alloy, in particular based on aluminum.

41. A method for producing a device according to any one of claims 1 to 40, comprising the following steps:
a. introducing an aperture (304) into a center plate part (311), wherein the aperture (304) corresponds to the course of the channel;
b. arranging a first and a second plate-shaped cover part (310, 312) on the center plate part (311) so as to form the channel;
c. sealingly fixing the plate-shaped cover parts (310, 312) to the center plate part (311); and
d. fixing an additional plate part (313) to the side of at least one of the cover parts (310, 312) that is located opposite the center plate part (311).

42. The method according to claim 41, **characterized in that** step c. includes the planar soldering of the cover parts (310, 312) to the center plate part (311), in particular by introducing the plate-shaped parts that are arranged on top of each other in a soldering furnace.

43. The method according to claim 41 or 42, **characterized in that** the aperture (304) of the center plate part (311) is introduced by way of laser cutting.

44. The method according to claim 41 or 42, **characterized in that** the aperture (304) of the center plate part (311) is introduced by way of stamping.

45. A method according to any one of claims 41 to 44, **characterized by** the following step:
e. attaching a plurality of guide bodies that extend substantially perpendicular relative to the center plate part (311), in particular by way of soldering.

46. A method according to any one of claims 41 to 45, **characterized by** the following step:
f. positioning the electrical elements relative to the heat sink (301) and applying a potting compound between the elements and the heat sink (301).

47. A motor vehicle, in particular a passenger motor vehicle, comprising
at least one electric motor for driving the motor vehicle, and a device according to any one of claims 1 to 40,
wherein the electric motor derives at least some of the drive energy thereof from the electrical elements (2, 102, 202).

48. The motor vehicle according to claim 47, **characterized in that** the motor vehicle has a hybrid drive comprising the electric motor and an internal combustion engine.

## Revendications

1. Dispositif servant au refroidissement d'éléments électriques, comprenant
un refroidisseur (1, 101, 201) traversé par un moyen de refroidissement,
une pluralité d'éléments électriques (2, 202) qui présentent à chaque fois une surface de fond et une surface latérale, où les surfaces de fond sont orientées pratiquement dans un plan,
où le refroidisseur (1, 101, 201) présente au moins un conduit (4, 5, 104, 105, 204, 205) traversé par un moyen de refroidissement et est en contact thermique avec les éléments électriques (2, 202), où le refroidisseur (1, 101, 201) s'étend pratiquement de façon parallèle au plan des surfaces de fond, où le conduit (4, 5, 104, 105, 204, 205) présente, dans le refroidisseur, un profil qui est adapté aux bordures des éléments électriques (2, 202),
**caractérisé en ce que** le refroidisseur (301) est configuré comme une pile se composant d'une pluralité d'éléments (310, 311, 312, 313) en forme de plaques, où la pile comprend une pièce centrale formant une plaque (311), où la pièce centrale formant une plaque présente une ouverture (304) servant à former le conduit, et au moins une plaque de recouvrement (310, 312) servant à former le conduit est fixée de façon étanche sur la pièce centrale formant une plaque, et une autre pièce formant une plaque (313) est fixée sur le côté de la plaque de recouvrement (312), placé à l'opposé de la pièce centrale formant une plaque (311).

2. Dispositif selon la revendication 1, **caractérisé en ce que** les surfaces formant le fond des éléments électriques (2, 202) sont contiguës au refroidisseur (1, 101, 201).

3. Dispositif selon la revendication 1 ou 2, **caractérisé en ce que** le refroidisseur (1, 101, 201) présente deux côtés opposés, où une pluralité d'éléments électriques (2, 202) est logée sur chacun des côtés.

4. Dispositif selon l'une quelconque des revendications précédentes, **caractérisé en ce que** les éléments électriques (2, 202) sont isolés électriquement par rapport au refroidisseur (1, 101, 201).

5. Dispositif selon l'une quelconque des revendications précédentes, **caractérisé en ce que** des corps conducteurs (3, 203) voisins des éléments électriques sont disposés sur le refroidisseur (1, 201), où les corps conducteurs (3, 203) s'étendent pratiquement de façon perpendiculaire au refroidisseur (1, 201) et sont en contact thermique avec les éléments électriques.

6. Dispositif selon la revendication 5, **caractérisé en ce que** les corps conducteurs (3, 203) sont assemblés par continuité de matière, en particulier par brasage, avec le refroidisseur (1, 101, 201).

7. Dispositif selon la revendication 5 ou 6, **caractérisé en ce qu'**au moins certains des corps conducteurs (203) sont configurés comme des godets ayant une paroi au moins partiellement circulaire, où un élément électrique (202) est logé à chaque fois dans l'un des corps conducteurs (203) en forme de godet.

8. Dispositif selon l'une quelconque des revendications 5 à 7, **caractérisé en ce qu'**au moins certains des corps conducteurs (3) sont configurés à chaque fois comme une barre disposée entre des éléments (2) électriques voisins.

9. Dispositif selon l'une quelconque des revendications 5 à 8, **caractérisé en ce que** les éléments électriques (2, 202) sont assemblés avec les corps conducteurs, par continuité de matière, en particulier au moyen d'une masse de scellement remplissant les éléments.

10. Dispositif selon l'une quelconque des revendications précédentes, **caractérisé en ce que** les éléments électriques (2, 102, 202) présentent pratiquement la forme d'un cylindre, où une surface frontale du cylindre correspond à la surface formant le fond de l'élément électrique (2, 102, 202).

11. Dispositif selon l'une quelconque des revendications précédentes, **caractérisé en ce que** les bordures des éléments électriques (2, 202) correspondent aux bords de la surface formant le fond des éléments (2, 202), où le conduit (4, 5, 104, 105, 204, 205) s'étend au moins partiellement en étant voisin des bords de plusieurs éléments (2, 202).

12. Dispositif selon la revendication 11, **caractérisé en ce que** le conduit (4, 5, 104, 105, 204, 205) suit, les uns après les autres, des tronçons des bords de plusieurs éléments, où une direction du conduit se modifie en alternance avec les éléments qui se suivent.

13. Dispositif selon la revendication 11 ou 12, **caractérisé en ce que** le profil du conduit (4, 5, 204, 205), le long des bords, est pratiquement en forme de cercle partiel.

14. Dispositif selon la revendication 11 ou 12, **caractérisé en ce que** le conduit (104, 105) présente un profil pratiquement en forme de zigzag.

15. Dispositif selon l'une quelconque des revendications précédentes, **caractérisé en ce que** le conduit (104, 105) se ramifie, dans son profil, en au moins deux conduits partiels (104c, 104d, 105c, 105d).

16. Dispositif selon la revendication 15, **caractérisé en ce que** les conduits partiels (104c, 104d, 105c, 105d) au moins au nombre de deux présentent, au total, à peu près la même section d'écoulement que le conduit non ramifié (104, 105).

17. Dispositif selon l'une quelconque des revendications précédentes, **caractérisé en ce que** le conduit (4, 5, 104, 105) est configuré comme une cavité fraisée dans une pièce métallique en forme de plaque, en particulier en aluminium.

18. Dispositif selon l'une quelconque des revendications 1 à 16, **caractérisé en ce que** le conduit (204, 205) est configuré comme un tube courbe, en particulier comme un profilé extrudé comprenant plusieurs chambres.

19. Dispositif selon l'une quelconque des revendications précédentes, **caractérisé en ce que** le refroidisseur (1, 101, 201) comprend au moins deux conduits (4, 5, 104, 105, 204, 205), en particulier montés en parallèle.

20. Dispositif selon la revendication 19, **caractérisé en ce que** les conduits (4, 5, 104, 105, 204, 205) au moins au nombre de deux présentent pratiquement la même longueur.

21. Dispositif selon la revendication 20, **caractérisé en ce que** la longueur du deuxième conduit (5, 105, 205) ne s'écarte pas de plus de 40 % environ, en particulier de plus de 20 % environ, par rapport à la longueur du premier conduit (4, 104, 204).

22. Dispositif selon l'une quelconque des revendications 19 à 21, **caractérisé en ce que** les conduits (4, 5, 104, 105, 204, 205) au moins au nombre de deux présentent à chaque fois une section d'écoulement pratiquement constante, pratiquement de la même dimension.

23. Dispositif selon la revendication 22, **caractérisé en ce que** la section d'écoulement du deuxième conduit (5, 105, 205) ne se différencie pas de plus de 30 % environ, en particulier de plus de 15 % environ, par rapport à la section d'écoulement du premier conduit (4, 104, 204).

24. Dispositif selon l'une quelconque des revendications précédentes, **caractérisé en ce que** les éléments électriques (2, 102, 202) sont des accumulateurs, en particulier des batteries au lithium-ion.

25. Dispositif selon l'une quelconque des revendications précédentes, **caractérisé en ce que** le refroidisseur (1, 101, 201) est raccordé à un circuit de réfrigération d'un système de climatisation d'un véhicule à moteur, où le moyen de refroidissement est un fluide frigorigène du système de climatisation.

26. Dispositif selon la revendication 25, **caractérisé en ce que** le fluide frigorigène est du R134a.

27. Dispositif selon la revendication 25 ou 26, **caractérisé en ce que** le refroidisseur (1, 101, 201) est disposé en étant monté en parallèle dans le circuit de réfrigération.

28. Dispositif selon la revendication 27, **caractérisé en ce qu'**une alimentation (11) en fluide frigorigène se ramifie en aval d'un accumulateur (9) et, en particulier, en amont d'un détendeur (10) du circuit de réfrigération.

29. Dispositif selon la revendication 27 ou 28, **caractérisé en ce qu'**une évacuation (13) du fluide frigorigène, depuis le refroidisseur, débouche en amont d'un évaporateur (14) du circuit de réfrigération et, en particulier, en aval d'un détendeur (10) du circuit de réfrigération.

30. Dispositif selon l'une quelconque des revendications 25 à 29, **caractérisé en ce que**, en amont du refroidisseur (1, 101, 201), un détendeur (12) est monté en série par rapport au refroidisseur, où le détendeur (12) est configuré en particulier comme un étranglement fixe.

31. Dispositif selon l'une quelconque des revendications 27 à 30, **caractérisé en ce qu'**une alimentation fournie au refroidisseur (1, 101, 201) et une arrivée, depuis le refroidisseur, sont intégrées respectivement, à l'origine, dans un détendeur (10) du circuit de réfrigération.

32. Dispositif selon l'une quelconque des revendications 25 à 31, **caractérisé en ce que** le flux de fluide frigorigène traversant le refroidisseur (1, 101, 201) est modifiable par une soupape pouvant être pilotée.

33. Dispositif selon l'une quelconque des revendications 25 à 32, **caractérisé en ce que** le conduit (4, 5, 104, 105, 204, 205) présente une longueur de moins de 1000 mm environ, en particulier de 650 mm environ.

34. Dispositif selon l'une quelconque des revendications 25 à 33, **caractérisé en ce que** le conduit (4, 5, 104, 105, 204, 205) présente une section d'écoulement comprise entre 5 mm² environ et 170 mm² environ, en particulier entre 30 mm² environ et 50 mm² environ.

35. Dispositif selon l'une quelconque des revendications 25 à 34, **caractérisé en ce qu'**un flux de fluide frigorigène total traversant le refroidisseur est compris entre 4 g/s environ et 5 g/s environ.

36. Dispositif selon l'une quelconque des revendications précédentes, **caractérisé en ce que** la pièce centrale formant une plaque (311) comprend au moins deux segments séparés (311a, 311b, 311c, 311d, 311e), configurés en n'étant pas d'un seul tenant.

37. Dispositif selon l'une quelconque des revendications précédentes, **caractérisé en ce que** la pièce centrale formant une plaque (311) présente en outre une pluralité d'ouvertures (314) en particulier de forme circulaire, où ces ouvertures sont disposées en venant en recouvrement formé par les surfaces de fond des éléments électriques.

38. Dispositif selon l'une quelconque des revendications précédentes, **caractérisé en ce que** la pièce centrale formant une plaque (311) et la plaque de recouvrement (310, 312) sont brasées les unes aux autres, sur une grande étendue.

39. Dispositif selon l'une quelconque des revendications précédentes, **caractérisé en ce qu'**au moins certains des éléments (310, 311, 312, 313) en forme de plaques présentent un placage par brasage sur une grande étendue.

40. Dispositif selon l'une quelconque des revendications précédentes, **caractérisé en ce que** les éléments (310, 311, 312, 313) en forme de plaques se composent d'un alliage de métaux légers, en particulier à base d'aluminium.

41. Procédé de fabrication d'un dispositif selon l'une quelconque des revendications 1 à 40, comprenant les étapes consistant
a. à ménager une ouverture (304) dans une pièce centrale formant une plaque (311), où l'ouverture (304) correspond au profil du conduit ;
b. à disposer une première et une deuxième pièces de recouvrement (310, 312), en forme de plaques, sur la pièce centrale formant une plaque (311) servant à former le conduit;
c. à fixer de façon étanche les pièces de recouvrement (310, 312), en forme de plaques, sur la pièce centrale formant une plaque (311);
d. à fixer une autre pièce formant une plaque (313) sur le côté d'au moins l'une des pièces de recouvrement (310, 312), ledit côté étant placé à l'opposé de la pièce centrale formant une plaque (311).

42. Procédé selon la revendication 41, **caractérisé en ce que** l'étape c. comprend un brasage - de grande étendue - des pièces de recouvrement (310, 312), sur la pièce centrale formant une plaque (311), en particulier par l'introduction, dans un four à braser, des pièces en forme de plaques disposées les unes sur les autres.

43. Dispositif selon la revendication 41 ou 42, **caractérisé en ce que** l'ouverture (304) de la pièce centrale formant une plaque (311) est réalisée par découpe au laser.

44. Dispositif selon la revendication 41 ou 42, **caractérisé en ce que** l'ouverture (304) de la pièce centrale formant une plaque (311) est réalisée par poinçonnage.

45. Procédé selon l'une quelconque des revendications 41 à 44, **caractérisé par** l'étape consistant e. à fixer, en particulier par brasage, une pluralité de corps conducteurs s'étendant pratiquement de façon perpendiculaire à la pièce centrale formant une plaque (311).

46. Procédé selon l'une quelconque des revendications 41 à 45, **caractérisé par** l'étape consistant f. à positionner les éléments électriques par rapport au refroidisseur (301) et à appliquer une masse de scellement entre les éléments et le refroidisseur (301).

47. Véhicule à moteur, notamment voiture particulière, comprenant
au moins un moteur électrique pour le système de propulsion du véhicule à moteur, et
un dispositif selon l'une quelconque des revendications 1 à 40,
où le moteur électrique reçoit son énergie de propulsion au moins partiellement en provenance des éléments électriques (2, 102, 202).

48. Véhicule à moteur selon la revendication 47, **caractérisé en ce que** le véhicule à moteur présente une propulsion hybride obtenue en utilisant le moteur électrique et le moteur à combustion interne.
